# FASCICULE DE BREVET EUROPEEN

(11) **EP 0 651 599 B1**
(45) Date de publication et mention de la délivrance du brevet: **27.12.1996**
(21) Numéro de dépôt: 94116754.6
(22) Date de dépôt: 24.10.1994
(51) Int. Cl.: H05K 3/30

(54) **Dispositif de fixation d'un composant électronique sur un circuit flexible, et boîtier comportant un tel dispositif**
Befestigungsvorrichtung für ein elekronisches Bauteil auf einer flexiblen Schaltung und Gehäuse mit einer derartigen Vorrichtung
Fastening device for an electronic component on a flexible circuit, and casing containing such a device

(30) Priorité: 02.11.1993 FR 9313106
(43) Date de publication de la demande: 03.05.1995
(73) Titulaire: SIEMENS AUTOMOTIVE S.A., 31036 Toulouse Cédex (FR)
(72) Inventeur: Jurek, Gilles, F-31830 Plaisance du Touch (FR)
(74) Mandataire: Fuchs, Franz-Josef, Dr.-Ing.

(56) Documents cités:
- PATENT ABSTRACTS OF JAPAN vol. 13, no. 196 (E-755) 10 Mai 1989 & JP-A-01 018 300

## Description

La présente invention concerne un dispositif de fixation d'un composant électronique sur un circuit flexible, et un boîtier comportant un tel dispositif.

Plus particulièrement, l'invention concerne la fixation d'un composant électronique lourd ou volumineux, sur un circuit flexible mis en place dans un boîtier électronique.

Il est déjà connu, de fixer un composant électronique sur un circuit imprimé rigide. Un tel composant peut être volumineux, ou non, lourd, ou non, cela ne pose pas de problème particulier pour son implantation. Par contre lorsque le circuit imprimé utilisé est un circuit flexible, il est impératif de fixer les composants sans provoquer, de déchirures ni d'amorces de ruptures. Dans le cas de composants de faibles dimensions et poids, il y a peu de risques de déchirures. Par contre, dans le cas de composants lourds ou volumineux, ces risques de déchirures sont importants. En outre certains composants (par exemple les connecteurs) doivent pouvoir supporter certains efforts lors du retrait ou de la mise en place de parties correspondantes. Dans ce cas, il est nécessaire que ces manoeuvres s'effectuent sans appliquer d'efforts sur le circuit flexible.

De même les vibrations auxquelles sont soumis les dispositifs électroniques, notamment lorsqu'ils sont mis en place dans un véhicule, ont tendance à provoquer des déchirures des circuits flexibles. Ces déchirures s'établissent préférentiellement aux alentours des composants lourds ou volumineux. En effet, en raison de leur masse propre, ces composants exercent des forces importantes sur le circuit flexible qui les entoure.

Pour pallier ces inconvénients les pièces lourdes ou volumineuses ne sont pas fixées sur les circuits flexibles. Ces composants sont en effet, généralement placés sur des circuits rigides distincts. Ces circuits rigides doivent ensuite être reliés au circuit flexible, ce qui complique le dispositif et augmente son coût.

Une autre solution consiste à employer des composants non traversants de manière à éliminer les risques de déchirures. Cette solution n'est pas satisfaisante, car elle est plus onéreuse et complique la réalisation du circuit imprimé flexible.

La présente invention a pour objet de pallier l'ensemble de ces inconvénients, et de créer un dispositif de fixation pour un composant électronique lourd ou volumineux sur un circuit flexible, sans détériorations du circuit flexible.

A cet effet la présente invention concerne un dispositif de fixation d'un composant électronique sur un circuit flexible, ledit composant étant muni de pattes de fixations de sections déterminées et le dit circuit flexible étant mis en place dans au moins partiellement un boîtier. Le dispositif selon l'invention se caractérise par le fait qu'il se compose d'un moyen de support solidaire du boîtier, placé entre le composant à fixer et le circuit flexible. Ce moyen de support est muni d'une pluralité d'ouvertures dont au moins deux présentent une section sensiblement égale à celles des pattes du composant à fixer. Les ouvertures restantes présentent une section sensiblement supérieure à celle des pattes.

Ainsi, le dispositif selon l'invention, permet de maintenir en place le composant par rapport au circuit flexible, sans le fixer directement sur ce circuit flexible. En effet au moins deux pattes de fixation du composant traversent des ouvertures du moyen de support. Ces ouvertures présentent une section sensiblement égale à celle des pattes de fixation. Les pattes de fixation sont donc fermement maintenues dans ces ouvertures. Le composant est ainsi solidarisé par rapport au moyen de support. Par contre, les autres pattes du composant, sont simplement insérées dans des ouvertures du moyen de support dont la section est sensiblement supérieure à celle des pattes de fixation. De ce fait, ces autres pattes, ne sont pas solidaires du moyen de support. L'extrémité des pattes dépassant du moyen de support est alors librement insérée dans les orifices du film flexible. Ces orifices ont des sections sensiblement supérieures à celles des pattes qu'ils reçoivent. Il n'y a donc pas de fixation mécanique entre le composant et le circuit flexible. Les pattes dépassant du circuit flexible sont simplement soudées sur la face inférieure de celui-ci.

On notera que le circuit flexible joue, vis à vis, du composant uniquement un rôle d'alimentation en courant. Le rôle de fixation mécanique, est quant à lui, réalisé par le moyen de support solidaire du boîtier. Ce partage des fonctions d'alimentation et de fixation, entre le circuit flexible et le moyen de support, permet avantageusement de réaliser un circuit flexible de forme simple et de faible coût. En outre, le circuit flexible ne supporte aucun effort de traction ou de torsion susceptible de le déténorer.

De manière avantageuse pour améliorer le maintien du composant, les deux ouvertures à section sensiblement égale à celles des pattes de fixation, sont disposées selon une diagonale du composant.

La présente invention concerne également un boîtier pour un dispositif électronique du type comportant, au moins un composant électronique à fixer sur un circuit flexible, le dit composant présentant une pluralité de pattes de fixation de section déterminée, le dit boîtier étant caractérisé en ce qu'il comporte:
- le circuit flexible placé dans le boîtier et adapté pour être connecté à une pluralité de composants électroniques munis de pattes de fixation traversant le circuit flexible et soudés sur une face inférieure de celui-ci, et présentant une pluralité d'orifices d'une section supérieure à celle des pattes et adaptée pour recevoir les pattes du composant à fixer, et
- un moyen de support, placé entre le circuit flexible et le composant à fixer, le dit moyen de suport étant solidaire du boîtier et comportant une pluralité d'ouvertures dont au moins deux ouvertures de section sensiblement égale à celle des pattes du composant à fixer, alors que les autres présentent une section sensiblement supérieure à celle des pattes de fixation.

Selon un mode de réalisation préférentiel, le moyen de support est muni d'un évidement adapté pour loger, au moins partiellement le composant à fixer. Le composant est ainsi maintenu en place, par rapport au moyen de support.

Pour améliorer la solidarisation du composant dans le moyen de support des godrons ( ou tout dispositif analogue) sont ménagés à la périphérie de l'évidement, de manière à bloquer en translation et en rotation, le composant par rapport au moyen de support.

D'autres objets, caractéristiques et avantages de la présente invention ressortiront, d'ailleurs de la description qui suit, à titre d'exemple non limitatif, en référence aux dessins annexés, dans lesquels:
- la figure 1: est une vue schématique en coupe montrant le dispositif selon l'invention,
- la figure 2: est une vue en plan montrant le dispositif selon l'invention mis en place dans un boîtier et dans laquelle le composant à fixer n'est pas représenté.

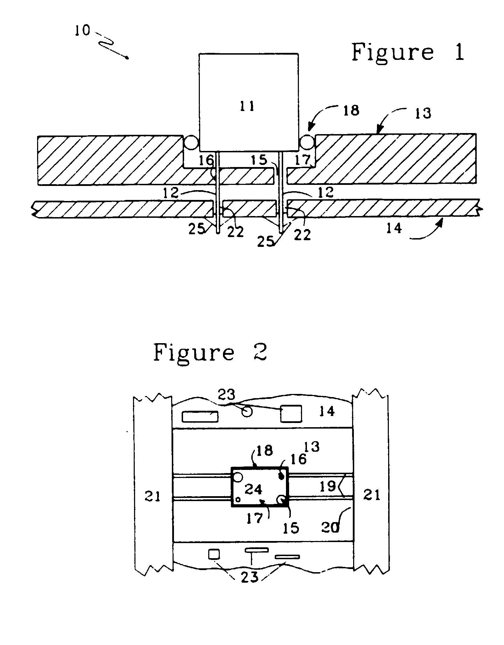

Selon la forme de réalisation décrite et représentée aux figures 1 et 2, le dispositif 10 selon l'invention comporte:
- un composant électronique 11, muni de pattes de fixation 12,
- un moyen de support 13 recevant les pattes du composant et,
- un circuit flexible 14.

Le composant à fixer 11, est par exemple, un relais, un connecteur...Ce composant est muni de pattes 12 classiques d'un diamètre déterminé. Les pattes du composant sont insérées dans le moyen de support 13.

Le moyen de support comporte une pluralité d'ouvertures 15, 16 adaptées pour recevoir les pattes du composant. Deux de ces ouvertures 16, dites de maintien, présentent un diamètre sensiblement égal à celui des pattes 12 du composant. Les autres ouvertures présentent un diamètre supérieur à celui des pattes. Les ouvertures de maintien 16, correspondent de préférence à deux pattes de fixation 12 placées selon une diagonale du composant (figure 1).

Le moyen de support 13 est muni d'un évidement 17 adapté pour recevoir la partie inférieure du composant a fixer. Cet évidement est muni sur sa périphérie d'un godron 18, adapté pour bloquer en translation et en rotation, le composant par rapport au moyen de support.

Le moyen de support 13 est également pourvu de nervures de raidissement 19. Ces nervures sont disposées à la périphérie de l'évidement 17.

Les extrémités latérales 20 du moyen de support 13 sont solidarisées à un boîtier 21, par exemple par emboîtement élastique.

Le circuit flexible 14 est de type classique. Il est constitué d'un film conducteur (ou de plusieurs), fixé sur un substrat en matériau synthétique flexible. Ce circuit flexible est muni d'une pluralité d'orifices 22 présentant une section supérieure à celle des pattes 12 et adaptés pour recevoir les pattes du composant à fixer. Le circuit flexible 14 est adapté pour recevoir un certain nombre d'autres composants 23 à fixer.

Le montage d'un tel dispositif est réalisé de la manière ci-après décrite.

Les pattes du composant à fixer sont insérées dans les ouvertures du moyen de support. Deux de ces pattes sont ainsi insérées, en force, dans les ouvertures de maintien 16. Les autres pattes s'insèrent librement dans les ouvertures 15 du moyen de support. Le composant à fixer est mis en place dans l'évidement 17, de sorte qu'il soit en contact avec le fond 24 de l'évidement. Le godron périphérique 18 le maintient fermement dans cette position. L'extrémité libre de chaque patte de fixation fait saillie du moyen de support 13 et est insérée dans l'orifice 22 correspondant du circuit flexible. Le circuit flexible est placé le plus près possible du moyen de support. Les extrémités des pattes de fixation sont ensuite soudées en 25, sur la face inférieure du circuit flexible.

Le composant est ainsi bloqué en position par rapport au moyen de support, lui même solidaire du boîtier et est relié électriquement au circuit flexible.

On notera que la fonction de maintien mécanique du composant est réalisée par le moyen de support, tandis que la fonction d'alimentation électrique, est réalisée par le circuit flexible. De ce fait aucun effort n'est transmis au circuit flexible ce qui évite de le détériorer.

Avantageusement, la relation mécanique entre le composant et le moyen de support est réalisée principalement par les ouvertures de maintien. Ces ouvertures sont simples à réaliser et de coût réduit.

Avantageusement pour améliorer l'immobilisation du composant par rapport au moyen de support, les ouvertures de maintien 16 sont réparties selon une diagonale du composant à fixer. Cependant il va de soi que, la répartition des ouvertures de maintien peut être différente de celle décrite. Cette répartition est à adapter à la forme et aux dimensions du composant à fixer.

En variante le nombre d'ouvertures de maintien peut être supérieur à deux. De même le nombre et la forme des pattes de fixation du composant peuvent être différents de ceux représentés.

En variante encore, le moyen de support peut être muni, ou non, d'un nombre quelconque de nervures de raidissement. De même, le moyen de support peut ne pas comporter d'évidement. Le nombre et la forme des godrons disposés à la périphérie de l'évidement peuvent différer de l'exemple représenté.

On notera, en outre, que le moyen de support isole thermiquement le circuit flexible du composant à fixer.

Bien entendu, l'invention n'est pas limitée au mode de réalisation ci-dessus décrit et représenté, et englobe toutes variantes à la portée de l'homme de l'art. Notamment le moyen de support peut être adapté pour recevoir plusieurs composants à fixer. En variante encore, les moyens de fixation du moyen de support sur le boîtier, sont de tous types appropriés.

## Revendications

1. Dispositif de fixation d'un composant électronique (11) sur un circuit flexible (14), le composant étant muni de pattes de fixation (12) présentant une section déterminée et le circuit flexible (14) étant mis en place dans au moins partiellement un boîtier (21), le dit dispositif étant caractérisé en ce qu'il se compose
d'un moyen de support (13) solidaire du boîtier (21), placé entre le composant (11) à fixer et le circuit flexible (14), le dit moyen de support (13) étant muni d'une pluralité d'ouvertures (15,16), dont au moins deux (16) présentent une section sensiblement égale à celui des pattes du composant à fixer alors que les autres présentent une section sensiblement supérieure à celle des pattes de fixation (12).

2. Dispositif selon la revendication 1, caractérisé en ce que les deux ouvertures (16) de sections sensiblement égales à celle des pattes de fixation, sont adaptées pour recevoir des pattes de fixation disposées en diagonale sur le composant (11) à fixer.

3. Dispositif selon la revendication 1 ou 2, caractérisé en ce que le moyen de support (13) présente un évidement (17) adapté pour recevoir, au moins partiellement le composant à fixer.

4. Dispositif selon la revendication 3, caractérisé en ce que le moyen de support (13) comporte au moins une nervure de raidissement (19) ménagée à la périphérie de l'évidement (17).

5. Dispositif selon la revendication 3 ou 4, caractérisé en ce qu'au moins un godron (18) est ménagé à la périphérie interne de l'évidement (17).

6. Boîtier pour dispositif électronique, du type comportant au moins un composant électronique (11) à fixer sur un circuit flexible, le dit composant présentant une pluralité de pattes de fixation (12) de sections déterminées, le dit boîtier étant caractérisé en ce qu'il comporte:
- le circuit flexible (14) placé dans le boîtier, et adapté pour être connecté à une pluralité de composants électroniques (23), munis de pattes de fixation traversant le circuit flexible et soudées sur une face inférieure de celui-ci, et présentant une pluralité d'orifices (22) d'une section supérieure à celle des pattes (12) et adaptée pour recevoir les pattes du composant à fixer, et
- un moyen de support (13), placé entre le circuit flexible et le composant à fixer, le dit moyen de support étant solidaire du boîtier et comportant une pluralité d'ouvertures (15, 16) dont au moins deux ouvertures (16) présentent des sections sensiblement égales à celles des pattes du composant à fixer alors que les autres présentent une section sensiblement supérieure à celles des pattes de fixation (12).

## Patentansprüche

1. Vorrichtung zum Befestigen eines elektronischen Bauelementes (11) an einer flexiblen Schaltung (14), wobei das Bauelement mit Befestigungsteilen (12) eines vorgegebenen Querschnitts versehen ist und die flexible Schaltung (14) zumindest teilweise in einem Gehäuse (21) angeordnet ist, welche Vorrichtung dadurch gekennzeichnet ist, daß sie aus einem mit dem Gehäuse (21) fest verbundenen Trägermittel (13) besteht, das zwischen dem zu befestigenden Bauelement (11) und der flexiblen Schaltung (14) angeordnet ist, wobei das Trägermittel (13) mit mehreren Öffnungen (15,16) verse-hen ist, von denen mindestens zwei (16) einen Querschnitt haben, der im wesentlichen gleich dem der Befestigungsteile des zu befestigenden Bauelementes ist, während die anderen einen Querschnitt haben, der deutlich größer als der der Befestigungsteile (12) ist.

2. Vorrichtung nach Anspruch 1, dadurch gekennzeichnet, daß die beiden Öffnungen (16), deren Querschnitt im wesentlichen gleich dem der Befestigungsteile ist, dazu geeignet sind, Befestigungsteile, die auf dem zu befestigenden Bauelement (11) in der Diagonale angeordnet sind, aufzunehmen.

3. Vorrichtung nach Anspruch 1 oder 2, dadurch gekennzeichnet, daß das Trägermittel (13) eine Ausnehmung (17) aufweist, die zumindest teilweise das zu befestigende Bauelement aufnehmen kann.

4. Vorrichtung nach Anspruch 3, dadurch gekennzeichnet, daß das Trägermittel (13) mindestens eine Versteifungsrippe (19) aufweist, die am Umfang der Ausnehmung (17) vorgesehen ist.

5. Vorrichtung nach Anspruch 3 oder 4, dadurch gekennzeichnet, daß mindestens ein Dichtungsteil (18) am inneren Umfang der Ausnehmung (17) vorgesehen ist.

6. Gehäuse für eine elektronische Vorrichtung mit mindestens einem elektronischen Bauelement (11), das an einer flexiblen Schaltung zu befestigen ist, wobei das Bauelement mehrere Befestigungsteile (12) eines vorgegebenen Abschnitts aufweist, dadurch gekennzeichnet, daß es aufweist:
- die flexible Schaltung (14), die in dem Gehäuse angeordnet und mit mehreren elektronischen Bauelementen (23) verbindbar ist, welche mit Befestigungsteilen versehen sind, die durch die flexible Schaltung hindurch verlaufen und an einer unteren Fläche derselben angeschweißt sind, sowie mehrere Öffnungen (22) aufweisen, deren Querschnitt größer als der der Befestigungsteile (12) ist und die Befestigungsteile des zu befestigenden Bauelementes aufnehmen können, und
- ein Trägermittel (13), das zwischen der flexiblen Schaltung und dem zu befestigenden Bauelement angeordnet ist, wobei das Trägermittel mit dem Gehäuse fest verbunden ist und mehrere Öffnungen (15,16), von denen mindestens zwei Öffnungen (16) einen Querschnitt haben, aufweist, der im wesentlichen gleich dem der Befestigungsteile des zu befestigenden Bauelementes ist, während die anderen einen Querschnitt haben, der deutlich größer als der der Befestigungsteile (12) ist.

## Claims

1. Device for fastening an electronic component (11) to a flexible circuit (14), the component being furnished with fastening lugs (12) having a specified cross-section and the flexible circuit (14) being set in place at least partially in a casing (21), the said device being characterized in that it is composed of
a support means (13) secured to the casing (21), placed between the component (11) to be fastened and the flexible circuit (14), the said support means (13) being furnished with a plurality of apertures (15, 16), at least two (16) of which have a cross-section substantially equal to that of the lugs of the component to be fastened whilst the others have a cross-section substantially greater than that of the fastening lugs (12).

2. Device according to Claim 1, characterized in that the two apertures (16) with cross-sections substantially equal to that of the fastening lugs are adapted to receive fastening lugs arranged diagonally on the component (11) to be fastened.

3. Device according to Claim 1 or 2, characterized in that the support means (13) has a recess (17) adapted to receive, at least partially, the component to be fastened.

4. Device according to Claim 3, characterized in that the support means (13) includes at least one stiffening rib (19) made at the periphery of the recess (17).

5. Device according to Claim 3 or 4, characterized in that at least one knurl (18) is made at the internal periphery of the recess (17).

6. Casing for an electronic device, of the type including at least one electronic component (11) to be fastened to a flexible circuit, the said component having a plurality of fastening lugs (12) with specified cross-sections, the said casing being characterized in that it includes:
- the flexible circuit (14) placed in the casing, and adapted so as to be connected to a plurality of electronic components (23), furnished with fastening lugs penetrating through the flexible circuit and welded to a lower face thereof, and having a plurality of orifices (22) with a cross-section greater than that of the lugs (12) and adapted so as to receive the lugs of the component to be fastened, and
- a support means (13), placed between the flexible circuit and the component to be fastened, the said support means being secured to the casing and including a plurality of apertures (15, 16), of which at least two apertures (16) have cross-sections substantially equal to those of the lugs of the component to be fastened whilst the others have a cross-section which is substantially greater than those of the fastening lugs (12).
